# EUROPÄISCHE PATENTANMELDUNG

(11) **EP 2 523 007 A2**
(43) Veröffentlichungstag der Anmeldung: **14.11.2012**
(21) Anmeldenummer: 12003806.2
(22) Anmeldetag: 14.05.2012
(51) Int. Cl.: G01R 31/04, H01R 9/24

(54) **Verfahren zum Prüfen und Herstellen einer elektrischen Schaltung**

(30) Priorität: 13.05.2011 DE 102011101467
(71) Anmelder: Engberts Mess-, Steuer- und Regelsysteme GmbH, 26188 Edelwecht (DE)
(72) Erfinder: Engberts, Uwe, 26188 Edewecht (DE); Meyer, Ingo, 26188 Edewecht (DE)
(74) Vertreter: Diehl & Partner GbR

(57) **Zusammenfassung**

Ein Verfahren zum Herstellen einer elektrischen Schaltung umfasst:
Aufstecken eines Adapters 3 auf Reihenklemmen der Schaltung, so dass Kontakte von mehreren der Reihenklemmen mit Kontakten 5 des Adapters elektrisch verbunden sind, wobei die Kontakte des Adapters an einer Schaltmatrix 27 eines Prüfsystems 1 angeschlossen sind, und/oder
Kontaktieren von Kontaktstellen der Schaltung mit mehreren Prüfkontakten 9, von denen ein jeder an der Schaltmatrix angeschlossen ist, wobei
einer der mehreren Prüfkontakte ausgewählt wird, eine an das Prüfsystem angeschlossene Kontaktidentifikationsfläche 95 mit dem ausgewählten Prüfkontakt berührt wird, um den ausgewählten Kontakt zu identifizieren; und
Ansteuern der Schaltmatrix derart, dass Anschlüsse 16, 17 einer Messvorrichtung 15 nacheinander mit verschiedenen Reihenklemmen bzw. Kontaktstellen der elektrischen Schaltung verbunden sind, und Ausführen von Messungen durch die Messvorrichtung bei jeweils verschiedenen Ansteuerungen der Schaltmatrix.

## Beschreibung

Die Erfindung betrifft ein Verfahren zum Prüfen und Herstellen einer elektrischen Schaltung.

Elektrische Schaltungen umfassen typischerweise mehrere elektrische Baugruppen, welche wiederum mehrere Kontakte aufweisen. Leitungsverbindungen zwischen verschiedenen Kontakten einer selben Baugruppe und Leitungsverbindungen zwischen Kontakten verschiedener Baugruppen ermöglichen ein bestimmungsgemäßes Funktionieren der Baugruppen selbst und eine Wechselwirkung der Baugruppen miteinander, so dass die elektrische Schaltung ihre bestimmungsgemäße Funktion ausführen kann. Das Erstellen der Leitungsverbindungen zwischen den Kontakten ist selbst arbeitsintensiv und fehleranfällig. Fehlende Leitungsverbindungen oder Leitungsverbindungen zwischen Kontakten, welche nicht einer Spezifikation einer gegebenen elektrischen Schaltung entsprechen, können zu einer Fehlfunktion der elektrischen Schaltung führen. Deshalb wird häufig die Korrektheit der Leitungsverbindungen einer elektrischen Schaltung in einem eigenständigen Prüfvorgang geprüft. Hierzu kann beispielsweise eine Bedienperson ein Messgerät mit zwei Prüfspitzen verwenden, mit welchen Kontakte der elektrischen Schaltung wahlweise kontaktiert werden und zum Beispiel ein Widerstand zwischen den Kontakten gemessen wird. Hierdurch können z. B. unerwünschte Kurzschlüsse oder fehlende Leitungsverbindungen entdeckt werden. Dieser Prüfvorgang ist arbeitsaufwändig und fehleranfällig, da die Bedienperson möglicherweise versehentlich nicht die gewünschten Kontakte der elektrischen Schaltung mit den Prüfspitzen kontaktiert und damit falsche Prüfergebnisse erzeugt werden können.

Es ist eine Aufgabe der vorliegenden Erfindung, Verfahren vorzuschlagen, welche ein Prüfen und Herstellen von elektrischen Schaltungen erleichtern.

Eine Ausführungsform der Erfindung betrifft das Prüfen und Herstellen einer elektrischen Schaltung, welche eine Mehrzahl von in einer Reihe nebeneinander angeordneten Reihenklemmen umfasst. Das Verfahren zum Prüfen und Herstellen der elektrischen Schaltung umfasst ein Aufstecken eines Adapters auf die Reihenklemmen, so dass Kontakte von mehreren der Reihenklemmen mit Kontakten des Adapters elektrisch verbunden sind, wobei die Kontakte des Adapters an einer Schaltmatrix eines Prüfsystems angeschlossen sind, ein Ansteuern der Schaltmatrix des Prüfsystems derart, dass wenigstens zwei Anschlüsse einer Messvorrichtung des Prüfsystems nacheinander mit verschiedenen Kontakten der Reihenklemmen verbunden sind, und ein Ausführen von Messungen durch die Messvorrichtung bei jeweils verschiedenen Ansteuerungen der Schaltmatrix.

Reihenklemmen werden häufig zur Herstellung von elektrischen Schaltungen in beispielsweise Schaltschränken eingesetzt. Hierbei ist, beispielsweise in einem Schaltschrank, eine Schiene, die häufig auch als Hutschiene bezeichnet wird, montiert, wobei die Schiene so konfiguriert ist, dass Reihenklemmen nebeneinander auf diese aufgeklemmt und somit an der Schiene befestigt werden können. Die Reihenklemmen weisen zwei oder mehr elektrisch miteinander verbundene Kontakte auf, an welche Drähte angeschlossen werden können. Das Anschließen der Drähte kann auf verschiedene Weisen geschehen, wie beispielsweise mittels einer Klemmschraube, eines Federkontakts oder eines Schneidkontakts, welcher an der Reihenklemme vorgesehen ist. Die Reihenklemmen weisen typischerweise auch eine Kontaktfläche auf, welche mit einer Prüfspitze elektrisch kontaktiert werden kann, um beispielsweise das elektrische Potential des Kontakts oder einen elektrischen Widerstand zwischen der Reihenklemme und einem anderen Kontakt der Schaltung zu messen.

Der Adapter ist so konfiguriert, dass er auf mehrere nebeneinander angeordnete Reihenklemmen so aufgesetzt werden kann, dass Kontakte von mehreren der Reihenklemmen gleichzeitig mit Kontakten des Adapters elektrisch verbunden sind. Die Kontakte des Adapters wiederum können zum Beispiel mittels flexibler Kabel an eine Schaltmatrix eines Prüfsystems angeschlossen werden. Das Prüfsystem umfasst eine Messvorrichtung, welche elektrische Eigenschaften, wie beispielsweise Widerstand, Induktivität und Kapazität messen kann. Das Prüfsystem ist so konfiguriert, dass es die Messvorrichtung durch Betätigen der Schaltmatrix nacheinander mit verschiedenen Kontakten des Adapters und damit mit Kontakten der Reihenklemmen verbinden kann und elektrische Eigenschaften beispielsweise zwischen Paaren von Kontakten der Reihenklemmen messen kann. Die jeweiligen Messergebnisse können mit einer Spezifikation der geprüften elektrischen Schaltung verglichen werden, um Fehler in der elektrischen Schaltung zu ermitteln. Dieser Vorgang kann automatisiert und schnell erfolgen, wobei mit einem einmal auf die Reihenklemmen aufgesteckten Adapter schnell elektrische Eigenschaften zwischen einer Vielzahl von Kombinationen der von dem Adapter kontaktierten Kontakte der Reihenklemmen gemessen werden können. Im Vergleich zu der herkömmlichen Methode, bei der eine Bedienperson mit zwei Prüfspitzen nacheinander die verschiedenen Kombinationen von Kontakten der Reihenklemmen kontaktiert und Messergebnisse mit der Spezifikation vergleicht, ermöglicht das hier beschriebene Verfahren eine starke Vereinfachung, Beschleunigung und Erhöhung der Messsicherheit, da die Möglichkeit einer versehentlichen Kontaktierung eines für einen bestimmten Messschritt falschen Kontakts der Reihenklemmen ausgeschlossen ist.

Gemäß Ausführungsformen umfasst der Adapter einen Verbinder zum Anschluss des Adapters an eine Anschlussbaugruppe der Schaltmatrix und einen Datenspeicher, wobei das Ausführen der Messungen ein Ansprechen des Datenspeichers und ein Bestimmen einer Anschlussposition des Verbinders an der Anschlussbaugruppe basierend auf einem Ergebnis des Ansprechens des Datenspeichers umfasst.

Es ist möglich, in dem Datenspeicher des Adapters Daten zu speichern, welche den Adapter kennzeichnen und insbesondere eindeutig identifizierbar machen. Da die Anschlussbaugruppe der Schaltmatrix eine Vielzahl von Anschlusspositionen aufweist und weiterhin mehrere der Adapter gleichzeitig über die Anschlussbaugruppe an die Schaltmatrix angeschlossen sein können, ermöglicht es dieser Datenspeicher, der über die Schaltmatrix angesprochen werden kann, Kontakte der Anschlussbaugruppe eindeutig Kontakten eines bestimmten Adapters automatisiert zuzuordnen.

Gemäß einer weiteren Ausführungsform umfasst das Verfahren ferner ein Anzeigen einer Darstellung der Reihenklemmen der elektrischen Schaltung auf einen Monitor und das Anzeigen einer Markierung, welche einem Benutzer einen Hinweis darauf gibt, auf welche Reihenklemmen der Vielzahl von Reihenklemmen der Adapter in einem nächsten Verfahrensschritt des Prüfverfahrens aufzustecken ist. Durch die bildliche Darstellung der Reihenklemmen der elektrischen Schaltung und die Markierung der Reihenklemmen, auf welche der Adapter aufzustecken ist, kann eine Bedienperson den Adapter auf die gewünschten Reihenklemmen aufbringen, wobei eine Wahrscheinlichkeit dafür, dass der Adapter auf die in dem nächsten Verfahrensschritt gerade nicht gewünschten Reihenklemmen aufgebracht wird, stark reduziert ist.

Gemäß einer weiteren Ausführungsform betrifft die Erfindung ein Verfahren zum Prüfen und Herstellen einer elektrischen Schaltung, welche eine Mehrzahl von von außen zugänglichen Kontaktstellen umfasst. Das Verfahren umfasst hierbei ein Kontaktieren der Kontaktstellen mit mehreren Prüfkontakten, von denen ein jeder an einer Schaltmatrix eines Prüfsystems angeschlossen ist, und Ansteuern der Schaltmatrix des Prüfsystems derart, dass wenigstens zwei Anschlüsse einer Messvorrichtung des Prüfsystems nacheinander mit verschiedenen Kontaktstellen der elektrischen Schaltung verbunden sind, und Ausführen von Messungen durch die Messvorrichtung bei jeweils verschiedenen Ansteuerungen der Schaltmatrix, wobei das Kontaktieren der mehreren Kontaktstellen umfasst: Auswählen eines der mehreren Prüfkontakte, Berühren einer an das Prüfsystem angeschlossenen Kontaktidentifikationsfläche mit dem ausgewählten Prüfkontakt, Ausführen einer Messung durch die Messvorrichtung bei jeweils verschiedenen Ansteuerungen der Schaltmatrix, und Identifizieren des ausgewählten Prüfkontakts basierend auf einem Ergebnis der Messungen. Die Messung zur Prüfung der elektrischen Schaltung kann dann in Abhängigkeit von einem Ergebnis der Identifizierung der ausgewählten Prüfkontakte durchgeführt werden.

Hierbei wird eine Vielzahl von Prüfkontakten gleichzeitig mit Kontaktstellen der elektrischen Schaltung in Kontakt gebracht. Die einzelnen Prüfkontakte sind zum Beispiel mittels flexibler Kabel mit der Schaltmatrix verbunden. Hierbei besteht ein Problem darin, denjenigen Prüfkontakt zu identifizieren, welcher mit einer bestimmten Kontaktstelle der elektrischen Schaltung in Kontakt gebracht wird. Eine Bedienperson kann nun willkürlich einen Prüfkontakt aus der Menge der zur Verfügung stehenden Prüfkontakte auswählen, um diesen mit einer gewünschten Kontaktstelle der elektrischen Schaltung in Kontakt zu bringen. Vor diesem Kontaktieren berührt die Bedienperson mit dem ausgewählten Prüfkontakt die Kontaktidentifikationsfläche so, dass zwischen dem Prüfkontakt und der Kontaktidentifikationsfläche ein elektrischer Kontakt entsteht. Dieser Kontakt wird durch das Prüfsystem registriert, wobei das Prüfsystem hierbei feststellen kann, welcher Prüfkontakt aus der Menge der zur Verfügung stehenden Prüfkontakte von der Bedienperson ausgewählt wurde. Damit hat die Steuerung Kenntnis darüber, welche der mehreren Prüfkontakte mit den jeweiligen Kontaktstellen verbunden sind und kann das darauffolgende Prüfen der elektrischen Schaltung unter dieser Kenntnis durchführen. Insbesondere kann aufgrund der Kenntnis der erfolgten Zuordnung von Prüfkontakten zu tatsächlich kontaktierten Kontaktstellen die Ansteuerung der Schaltmatrix so erfolgen, dass in jedem der hierfür nötigen Meßschritte zwei oder mehr gewünschte Kontaktstellen über die Schaltmatrix unter Berücksichtigung der Zuordnung miteinander verbunden werden und elektrische Eigenschaften zwischen den verbundenen Kontaktstellen gemessen werden können.

Gemäß einer Ausführungsform hierin umfasst das Verfahren ferner Anzeigen einer Darstellung der Kontaktstellen auf einem Monitor und Anzeigen einer Markierung, welche anzeigt, welche der Kontaktstellen in einem nächsten Verfahrensschritt mit einem Prüfkontakt kontaktiert werden soll. Eine Bedienperson, welche für einen nächsten Kontaktierungsschritt einen der Prüfkontakte aus der Menge der zur Verfügung stehenden Prüfkontakte auswählt, diesen mit der Kontaktidentifikationsfläche in Kontakt bringt und sodann mit der auf dem Monitor markierten Kontaktstelle in Kontakt bringt, kann somit auf einfache Weise die für eine Prüfung der elektrischen Schaltung notwendigen Kontaktierungen vornehmen.

Gemäß einer Ausführungsform umfassen die Prüfkontakte jeweils einen Magneten, um den Prüfkontakt mittels Magnetkraft an einer der Kontaktstellen zu befestigen.

Ferner ist es möglich, einen oder mehrere Fehler in der elektrischen Schaltung durch Auswerten der durch die Messvorrichtung durchgeführten Messungen zu ermitteln und diese Fehler im Rahmen der Herstellung der elektrischen Schaltung zu beheben.

Ausführungsformen der Erfindung werden nachfolgend anhand von Figuren näher erläutert. Hierbei zeigt:
- Figur 1: eine Teilansicht einer elektrischen Schaltung,
- Figur 2: ein Prüfsystem zum Überprüfen der in Figur 1 gezeigten elektrischen Schaltung,
- Figur 3: eine Darstellung der elektrischen Schaltung auf einem Monitor des in Figur 2 gezeigten Prüfsystems während eines Prüfverfahrens.

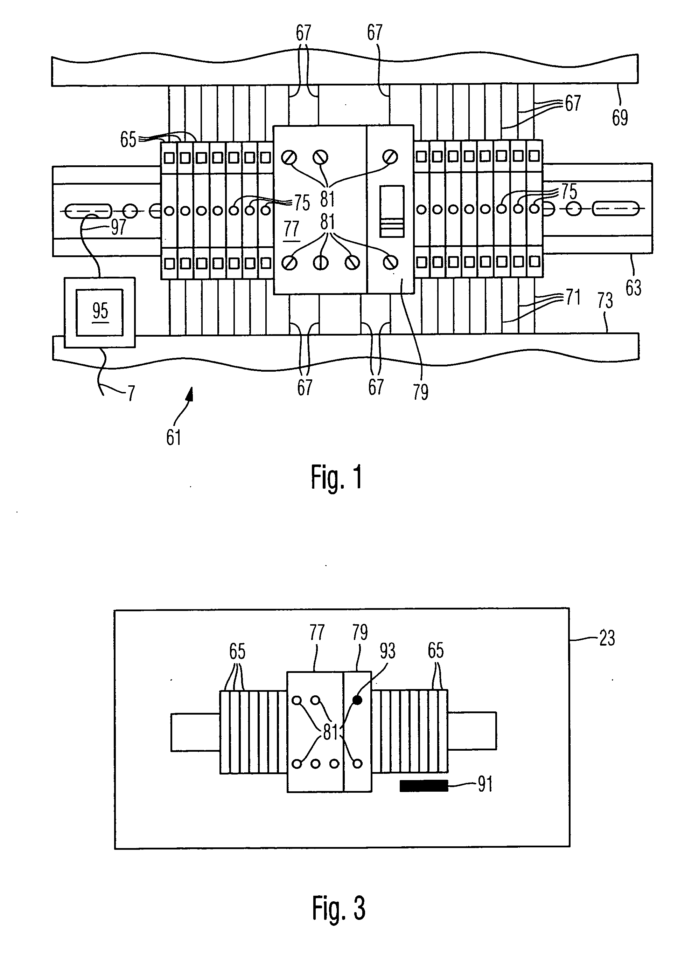

Eine in Figur 1 schematisch dargestellte elektrische Schaltung 61 umfasst eine Hutschiene 63, welche zusammen mit anderen Komponenten der elektrischen Schaltung beispielsweise in einem Schaltschrank montiert sein kann. Auf der Hutschiene 63 ist eine Vielzahl von Anreihklemmen 65 montiert, welche Kontakte zur Bereitstellung von elektrischen Leitungsverbindungen zwischen Komponenten der elektrischen Schaltung aufweisen. An in der Darstellung der Figur 1 oben liegende Kontakte der Reihenklemmen 61 sind Leitungen 67 angeschlossen, welche in einen Kabelkanal 69 führen, durch diesen weiterverlaufen und an andere, in Figur 1 nicht dargestellte Komponenten der elektrischen Schaltung 61 oder an andere Reihenklemmen 65 angeschlossen sind. Ähnlich sind an in der Darstellung der Figur 1 untere Kontakte der Reihenklemmen 65 an Leitungen 71 angeschlossen, welche in einen Kabelkanal 73 führen, in diesem weiter verlaufen und an weitere Komponenten der elektrischen Schaltung 61 angeschlossen sind. Eine jede der Reihenklemmen 65 verbindet den oberen Kontakt leitend mit dem unteren Kontakt über eine in Figur 1 nicht dargestellte und in der Reihenklemme 65 enthaltene Leitung. Diese Leitung ist über eine Öffnung 75 in der Reihenklemme von außen zugänglich, so dass beispielsweise eine Prüfspitze in die Öffnung 75 eingeführt werden kann, um mit der Leitung einen elektrischen Kontakt zu schließen.

Auf der Hutschiene 63 sind noch weitere Komponenten der elektrischen Schaltung montiert, welche von den Reihenklemmen 65 verschieden sind. In dem dargestellten Beispiel sind dies ein Timer 77 und eine Sicherung 79. Mit deren Anschlüssen sind ebenfalls Leitungen 67 und 71 verbunden. In dem dargestellten Beispiel werden die Kontakte der zusätzlichen Komponenten 77, 79 mittels Schraubkontakten 81 geschlossen, deren Schrauben von außen zugänglich sind und ebenfalls Kontaktstellen für eine Prüfung der elektrischen Schaltung bereitstellen.

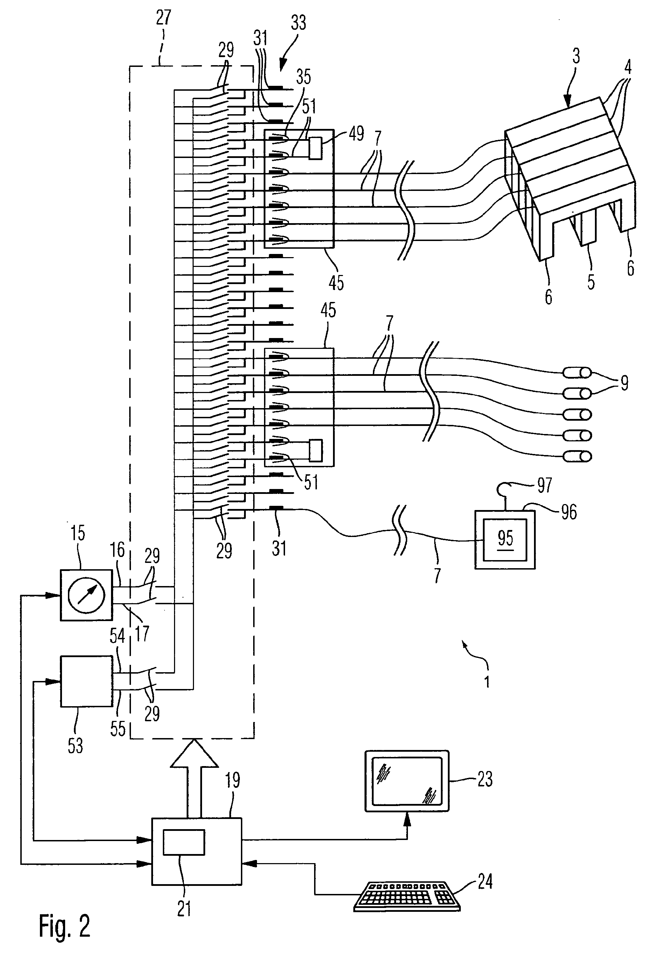

Figur 2 zeigt ein Prüfsystem 1, welches zur Überprüfung der in Figur 1 gezeigten elektrischen Schaltung 61 eingesetzt werden kann. Hierzu umfasst das Prüfsystem 1 einen Adapter 3, welcher eine Mehrzahl von Adapterelementen 4 umfasst, wobei ein jedes der Adapterelemente 4 eine Kontaktspitze 5 aufweist, um in eine Öffnung 75 einer Reihenklemme 65 einzudringen und mit dieser einen elektrischen Kontakt zu schließen. Hierzu umfassen der Adapter oder dessen Adapterelemente 4 Klemmbeine 6, welche auf Reihenklemmen aufgeklemmt werden können, um den Adapter 3 auf einer Mehrzahl von Reihenklemmen 65 zu haltern. In dem in Figur 2 dargestellten Beispiel umfasst der Adapter 3 fünf Adapterelemente 4, so dass der Adapter 3 einen elektrischen Kontakt gleichzeitig mit fünf Reihenklemmen 65 der Figur 1 herstellen kann. Es ist jedoch möglich, andere Adapter 3 mit einer größeren oder einer kleineren Zahl von Adapterelementen einzusetzen.

Die Kontakte 5 der Kontaktelemente 4 sind über flexible Kabel 7 mit einem Steckverbinder 45 zum Anschluss des Adapters 3 an eine Schaltmatrix 27 des Prüfsystems 1.

Das Prüfsystem 1 umfasst ferner fünf Magnetkontakte 9, welche über flexible Kabel 7 ebenfalls mit einem Steckverbinder 45 zum Anschluss der Magnetkontakte 9 an die Schaltmatrix verbunden sind. Die Magnetkontakte 9 sind zur Kontaktierung der Kontaktstellen 81 der elektrischen Schaltung 61 (vgl. Figur 1) vorgesehen, wobei die Magnetkontakte 9 einen Permanentmagneten umfassen, welcher so dimensioniert ist, dass durch dessen Magnetkraft die Kontakte 9 an den Kontaktstellen 81 gehalten werden, sobald eine Bedienperson den Kontakt zwischen Magnetkontakt 9 und Kontaktstelle 81 hergestellt hat.

Das Prüfsystem 1 umfasst ferner eine Messvorrichtung 15 mit zwei Anschlüssen 16 und 17 und ist dazu konfiguriert, wenigstens eine elektrische Eigenschaft einer elektrischen Schaltung zu messen, die an die Anschlüsse 16, 17 angeschlossen ist. Die elektrische Eigenschaft kann einen Ohm'schen Widerstand, eine Kapazität und eine Induktivität umfassen. In dem hier erläuterten Ausführungsbeispiel weist die Messvorrichtung 15 zwei Anschlüsse 16 und 17 auf. Es ist jedoch auch möglich, dass die Messvorrichtung eine größere Zahl von Anschlüssen aufweist. Beispielsweise kann eine Messvorrichtung mit vier Anschlüssen vorgesehen sein, um eine 4-Pol-Messung der elektrischen Eigenschaften zu ermöglichen.

Zur Prüfung der elektrischen Schaltung 61 sind die beiden Anschlüsse 16, 17 der Messvorrichtung 15 mit den Kontakten 75, 81 der elektrischen Schaltung 61 in verschiedener Kombination zu verbinden, so dass durch die Messvorrichtung 15 Messungen an der elektrischen Schaltung 61 vorgenommen werden können und mit vorbestimmten Sollwerten für die jeweiligen Messungen verglichen werden können, um eine Korrektheit der elektrischen Schaltung 61 festzustellen oder einen Fehler in der elektrischen Schaltung 61 zu erkennen. Hierzu wird die Messvorrichtung 15 von einer Rechnersteuerung 19 gesteuert, welche ebenfalls Messergebnisse der Messanordnung 15 ausliest und die entsprechenden Vergleichsrechnungen durchführt. Die Rechnersteuerung 19 umfasst einen Speicher 21, in welchem Information zu der Konfiguration der zu prüfenden elektrischen Schaltung 61 und gegebenenfalls zu weiteren elektrischen Schaltungen anderer Bauart, welche nachfolgend geprüft werden können, gespeichert sind. An die Rechnersteuerung 19 können die üblichen Ausgabevorrichtungen, wie beispielsweise ein Bildschirm 23, und Eingabevorrichtungen, wie beispielsweise eine Tastatur 24, angeschlossen sein.

Das Prüfsystem 1 umfasst ferner die Schaltmatrix 27, die durch die Rechnersteuerung 19 kontrolliert wird. Die Schaltmatrix 27 umfasst eine Vielzahl einzelner Schalter 29, um die Anschlüsse 16, 17 der Messvorrichtung 15 wahlweise mit Kontakten 31 zu verbinden, welche an einer Anschlussbaugruppe 33 des Prüfgeräts 13 bereitgestellt sind. Die Anschlussbaugruppe 33 haltert diese Kontakte 31 derart, dass diese von außen zugänglich sind und mit Kontakten 35 der Steckverbinder 45 verbunden werden können, die zur Kopplung der prüfenden elektrischen Schaltung 61 an das Prüfsystem 1 dienen. Hierzu umfassen die Steckverbinder 45 Kontakte 35 zur Verbindung mit den Kontakten 31 der Anschlussbaugruppe 33. Die Kontakte 35 sind an einem Steckerbinder 45 gehaltert, welcher so konfiguriert ist, dass er durch Anbringen an einer geeigneten Position der Anschlussbaugruppe 33 die Kontakte 35 des Verbinders 45 gleichzeitig mit einer Gruppe von einander benachbarten Kontakten 31 der Anschlussbaugruppe 33 in Verbindung bringt. Hierbei kann der Steckverbinder 45 an verschiedenen, auswählbaren Stellen an die Anschlussbaugruppe 33 gekoppelt werden, so dass die Kontakte 35 des Steckverbinders 45 in Abhängigkeit von der gewählten Stelle andere Gruppen von Kontakten 31 der Verbindungsbaugruppe 33 kontaktieren.

Um jedoch eine erfolgreiche Prüfung der Leitungsanordnung 3 vornehmen zu können, ist eine Kenntnis darüber, an welche Kontakte 31 der Anschlussbaugruppe 33 die Kontakte 75, 81 der elektrischen Schaltung 61 angeschlossen sind, wesentlich, um die Schaltmatrix 27 zur Durchführung eines gewünschten Messprogramms anzusteuern.

Das Prüfsystem 1 ist dazu konfiguriert, Positionen, an welchen die Steckverbinder 45 an der Anschlussbaugruppe 33 angeschlossen sind, automatisch zu erkennen. Hierzu umfasst der Adapter 3 oder der Steckverbinder 45 einen Speicher 49 mit Anschlüssen 51, die ebenfalls an durch den Steckverbinder 45 bereitgestellten Kontakten 31 angeschlossen sind, so dass die Anschlüsse 51 des Speichers 49 mit den Kontakten 31 der Anschlussbaugruppe 33 in Kontakt stehen, sobald der Steckverbinder 45 an die Anschlussbaugruppe 33 angeschlossen ist.

Das Prüfsystem 1 umfasst ferner eine Speicherauslesevorrichtung 53 mit Anschlüssen 54 und 55, welche an die Schaltmatrix 27 angeschlossen sind, so dass Schalter 29 der Schaltmatrix 27 durch die Rechnersteuerung 19 so betätigt werden können, dass die Anschlüsse 54 und 55 der Speicherauslesevorrichtung 53 mit den Anschlüssen 51 des Speichers 49 verbunden sind. Bei einer derartigen Ansteuerung der Schaltmatrix 27 kann die Speicherauslesevorrichtung 53 den Inhalt des Speichers 49 auslesen und an die Rechnersteuerung 19 übermitteln. Der Inhalt des Speichers 49 kann Information enthalten, die es ermöglicht, den Adapter 3 eindeutig zu identifizieren und damit auch den Typ des Verbinders 10 der elektrischen Schaltung 61 zu identifizieren, der über den Steckverbinder 45 an die Anschlussbaugruppe 33 angeschlossen ist.

Darüber hinaus ist es möglich, den Steckverbinder 45 an einer beliebigen Position der Anschlussbaugruppe 33 an diese anzuschließen und sodann ein Programm auszuführen, welches es ermöglicht, die Position zu ermitteln, an welcher ein bestimmter Adapter 3 mit seinem Steckverbinder 45 an die Anschlussbaugruppe 33 angeschlossen ist. Hierzu steuert die Rechnersteuerung 19 die Schaltmatrix 27 der Reihe nach so an, dass die Anschlüsse 54, 55 der Speicherauslesevorrichtung mit verschiedenen Kombinationen von Paaren der Anschlüsse 31 der Anschlussbaugruppe 33 verbunden sind. Bei einer jeden Kombination der mit den Anschlüssen 54, 55 verbundenen Kontakte 31 veranlasst die Rechnersteuerung 19 einen Speicherausleseversuch durch die Speicherauslesevorrichtung 53. Dieser Ausleseversuch wird nur dann Erfolg haben, wenn durch die Schaltmatrix das Paar von Kontakten 31 mit den Anschlüssen 54, 55 der Speicherauslesevorrichtung 53 verbunden ist, an welche die Anschlüsse 51 des Speichers 49 des Adapters 3 angeschlossen sind. Dann liefert der Speicherausleseversuch zudem noch die Information zur Identifizierung des angeschlossenen Adapters 3. Durch systematische Ansteuerung der Schaltmatrix und Durchführen eines Speicherausleseversuchs bei einer jeden Ansteuerung der Schaltmatrix ist es somit möglich, die Position der Kontakte 31 an der Anschlussbaugruppe 33 festzustellen, an welche ein Steckverbinder 45 eines bestimmten Adapters 3 angeschlossen ist.

Figur 3 zeigt eine von dem Messprogramm des Prüfsystems 1 erzeugte Darstellung auf dem Bildschirm 23. Die Darstellung ist eine schematische Darstellung, die dem tatsächlichen Aufbau der in Figur 1 gezeigten elektrischen Schaltung 61 entspricht. So ist für eine Bedienperson erkennbar, dass die Reihenklemmen 65, der Timer 77 und die Sicherung 79 auf dem Bildschirm 23 dargestellt sind. Auf dem Bildschirm 23 befinden sich ferner eine Darstellung einer Markierung 91 und eine Darstellung einer Markierung 93. Die Markierung 91 markiert diejenigen Reihenklemmen, auf welche die Bedienperson den Adapter 3 für einen nächsten Messschritt aufklemmen soll. Die Markierung 93 markiert diejenige Kontaktstelle 81, mit welcher die Bedienperson einen der Magnetkontakte 9 als Nächstes aufbringen soll. Hierzu muss die Bedienperson einen der Magnetkontakte 9 aus der Vielzahl der Magnetkontakte auswählen und an die der Markierung 93 auf dem Bildschirm 23 entsprechende Kontaktstelle 81 der elektrischen Schaltung 61 drücken. Da die Magnetkontakte 9 in einer größeren Vielzahl an das Prüfsystem 1 angeschlossen sind und schwer voneinander unterscheidbar sind, wird bei der Auswahl eines Magnetkontakts 9 und dessen Andrücken an eine Kontaktstelle 81 wie folgt vorgegangen:
Die Bedienperson wähl willkürlich aus der Menge der zur Verfügung stehenden Magnetkontakte 9 einen aus und berührt mit diesem eine metallische Kontaktidentifikationsfläche 95, welche über eine flexible Leitung 7 ebenfalls an einen Kontakt 31 der Schaltmatrix angeschlossen ist. Die Kontaktidentifikationsfläche 95 kann beispielsweise an einem isolierenden Rahmen 96 vorgesehen sein, welcher einen Haken 97 aufweist, mit welchem die Kontaktidentifikationsfläche 95 zum Beispiel an einer Befestigungsöffnung der Hutschiene 63 in geringer Entfernung von den Kontaktstellen 81 befestigt werden kann. Das Berühren der Kontaktidentifikationsfläche 95 mit dem ausgewählten Magnetkontakt 9 wird von dem Prüfsystem detektiert, und durch Betätigen der Schaltmatrix und Messen beispielsweise des Widerstands zwischen den Anschlüssen 16 und 17 der Messvorrichtung 15 kann die Steuerung des Prüfsystems 1 denjenigen Magnetkontakt 9 identifizieren, welcher von der Bedienperson ausgewählt wurde. Das Identifizieren des Magnetkontakts 9 kann beispielsweise durch Ausgabe eines Tonsignals quittiert werden. Erst dann, d. h. nachdem das Prüfsystem den ausgewählten Magnetkontakt 9 identifiziert hat, bringt der Benutzer diesen ausgewählten Prüfkontakt 9 mit derjenigen Kontaktstelle 81 der elektrischen Schaltung 61 in Kontakt, welche durch die Markierung 93 auf dem Bildschirm 23 markiert ist. Auf diese Weise können nacheinander alle Kontaktstellen oder die in einem gewissen Messschritt gewünschten Kontaktstellen 81 der elektrischen Schaltung 61 mit Magnetkontakten 9 kontaktiert werden, wobei dann auch die Zuordnung zwischen den Prüfkontakten 9 und den mit diesen jeweils kontaktierten Kontaktstellen für die Steuerung 19 bekannt ist.

Sobald die für den Messschritt gewünschten Kontaktstellen 61 kontaktiert und die für den Messschritt gewünschten Reihenklemmen 65 mit einem Adapter 3 versehen sind, wird ein an die elektrische Schaltung 61 angepasstes Messprogramm gestartet, in welchem nacheinander verschiedene Kontakte 75, 81 der Schaltung 61 über die Schaltmatrix an die Messvorrichtung 15 angeschlossen werden und elektrische Eigenschaften bestimmt werden, die zwischen den gerade kontaktierten Kontakten 75, 81 vorliegen.

Die Ansteuerung der Schaltmatrix erfolgt hierbei unter Berücksichtung der Zuordnung der Prüfkontakte 9 zu tatsächlich kontaktierten Kontaktstellen 81 so, dass in jedem der hierfür nötigen Messschritte zwei oder mehr gewünschte Kontaktstellen 75, 81 über die Schaltmatrix unter Berücksichtigung der Zuordnung miteinander verbunden werden und elektrische Eigenschaften zwischen den verbundenen Kontaktstellen 75, 81 gemessen werden können.

Die Steuerung 19 kann diese gemessenen elektrischen Eigenschaften mit Soll-Werten vergleichen und Abweichungen zwischen gemessenen Werten und Soll-Werten, welche beispielsweise einen Schwellenwert überschreiten, als Fehler in der elektrischen Schaltung 61 identifizieren. Den Fehlern entsprechende Fehlermeldungen können beispielsweise auf dem Bildschirm 23 dargestellt werden und die Bedienperson dazu veranlassen, diese Fehler zu beheben, so dass schließlich die funktionstüchtige gewünschte elektrische Schaltung 61 hergestellt ist.

In dem vorangehend beschriebenen Ausführungsbeispiel werden aus den mehreren zur Verfügung stehenden Prüfkontakten 9 jeweils einzelne willkürlich ausgewählt und mit der Kontaktidentifizierungsfläche 95 in Kontakt gebracht, so dass die Steuerung den gerade ausgewählten Prüfkontakt 9 identifizieren und die Zuordnung zwischen den Prüfkontakten 9 und den durch diese jeweils kontaktierten Kontaktstellen 81 in der nachfolgenden Prüfung der elektrischen Schaltung berücksichtigen kann. Ein ähnliches Verfahren kann auch für die Auswahl von Adaptern 3 zum Aufstecken auf Anreihklemmen angewendet werden, wenn eine Mehrzahl von Adaptern 3 an das Prüfsystem 1 angeschlossen ist und die mehreren Adapter mit der elektrischen Schaltung zu verbinden sind, um die Prüfung der elektrischen Schaltung durchzuführen. Die Adapter 3 weisen jeweils eine Prüfspitze 5 oder einen anderen exponierten Kontakt auf, welcher mit der Kontaktidentifizierungsfläche 95 in Kontakt gebracht werden kann, so dass die Steuerung dieses In-Kontakt-Bringen identifizieren kann. Damit kann eine Bedienperson, welche die Aufgabe hat, einen Adapter 3 an der durch die Markierung 91 (vgl. Figur 3) bezeichneten Stelle auf die Reihenklemmen 65 aufzubringen, aus der zur Verfügung stehenden Menge von Adaptern willkürlich einen auswählen, diesen mit der Kontaktidentifizierungsfläche 95 in Kontakt bringen und sodann an der durch die Markierung 91 bezeichneten Stelle auf die Reihenklemmen aufbringen. Damit ist der Vorgang des Aufbringens der Adapter auf die Reihenklemmen besonders flexibel, da nicht verlangt werden muss, dass ein bestimmter von mehreren gleichen Adaptern auf bestimmte Reihenklemmen aufgebracht werden muss. Falls es jedoch nötig sein sollte, dass ein bestimmter Adapter, welcher sich von anderen Adaptern beispielsweise hinsichtlich der Anzahl der Adapterelemente 4 unterscheidet auf bestimmte Reihenklemmen aufgebracht werden soll, so kann die Steuerung zum einen feststellen, welcher der zur Verfügung stehenden Adapter von der Bedienperson ausgewählt wurde, und sie kann den ausgewählten Adapter aufgrund des Inhalts des Speichers 49 des Adapters auch identifizieren und somit überprüfen, ob die Bedienperson den gerade gewünschten Adapter ausgewählt hat. Falls dies nicht der Fall ist, kann beispielsweise ein Warnsignal ausgegeben werden.

In den vorangehend beschriebenen Ausführungsbeispielen wird die Markierung, welche auf dem Bildschirm anzeigt, wo der nächste Prüfkontakt oder der nächste Adapter in der zu prüfenden elektrischen Schaltung aufzustecken ist, bereits auf dem Bildschirm angezeigt, bevor die Bedienperson einen nächsten Prüfkontakt bzw. Adapter aus der Menge der zur Verfügung stehenden Prüfkontakte bzw. Adapter auswählt. Es ist jedoch auch möglich die Steuerung so zu gestalten, dass die Bedienperson zuerst einen nächsten Prüfkontakt oder nächsten Adapter willkürlich aus der Menge der zur Verfügung stehenden Prüfkontakte bzw. Adapter auswählt und mit der Kontaktidentifikationsfläche in Kontakt bringt und dann erst die entsprechende Markierung auf dem Bildschirm dargestellt wird.

## Patentansprüche

1. Verfahren zum Herstellen einer elektrischen Schaltung, wobei die elektrische Schaltung (61) eine Mehrzahl von in einer Reihe nebeneinander angeordneten Reihenklemmen (65) umfasst, und wobei das Verfahren umfasst:
Aufstecken eines Adapters (3) auf die Reihenklemmen (65), so dass Kontakte (75) von mehreren der Reihenklemmen mit Kontakten (5) des Adapters (3) elektrisch verbunden sind, wobei die Kontakte (5) des Adapters (3) an einer Schaltmatrix (27) eines Prüfsystems (1) angeschlossen sind; und
Ansteuern der Schaltmatrix (27) des Prüfsystems (1) derart, dass wenigstens zwei Anschlüsse (16,17) einer Messvorrichtung (15) des Prüfsystems (1) nacheinander mit verschiedenen Kontakten (75) der Reihenklemmen (65) verbunden sind, und Ausführen von Messungen durch die Messvorrichtung (15) bei jeweils verschiedenen Ansteuerungen der Schaltmatrix (27).

2. Verfahren nach Anspruch 1, wobei der Adapter (3) einen Verbinder (45) zum Anschluss an eine Anschlussbaugruppe (33) der Schaltmatrix (27) und einen Datenspeicher (49) umfasst, und wobei das Ausführen der Messungen ein Ansprechen des Datenspeichers (49) und ein Bestimmen einer Anschlussposition des Verbinders an der Anschlussbaugruppe (33) basierend auf einem Ergebnis des Ansprechens des Datenspeichers (49) umfasst.

3. Verfahren nach Anspruch 1 oder 2, wobei der Adapter (3) wahlweise auf verschiedene der Mehrzahl von Reihenklemmen (65) aufsteckbar ist, und wobei das Verfahren ferner umfasst:
Anzeigen einer Darstellung der Reihenklemmen (65) auf einem Monitor (23) und Anzeigen einer ersten Markierung (91), welche anzeigt, auf welche der Reihenklemmen (65) in einem nächsten Verfahrensschritt der Adapter (3) aufgesteckt werden soll.

4. Verfahren nach einem der Ansprüche 1 bis 3, wobei mehrere Adapter (3) zum Aufstecken auf Reihenklemmen (65) zur Verfügung stehen, und wobei das Verfahren ferner umfasst:
Auswählen eines der mehreren Adapter (3), Berühren einer an das Prüfsystem angeschlossenen Kontaktidentifikationsfläche (95) mit dem ausgewählten Adapter (3), Ausführen einer Messung durch die Messvorrichtung (15) bei jeweils verschiedenen Ansteuerungen der Schaltmatrix (27), und
Identifizieren des ausgewählten Adapters (3) basierend auf einem Ergebnis der Messung.

5. Verfahren zum Herstellen einer elektrischen Schaltung, wobei die elektrische Schaltung (61) eine Mehrzahl von Kontaktstellen (81) umfasst, und wobei das Verfahren umfasst:
Kontaktieren der Kontaktstellen (81) mit mehreren Prüfkontakten (9), von denen ein jeder an einer Schaltmatrix (27) eines Prüfsystems (1) angeschlossen ist; und
Ansteuern der Schaltmatrix (27) des Prüfsystems (1) derart, dass wenigstens zwei Anschlüsse (16, 17) einer Messvorrichtung (15) des Prüfsystems (1) nacheinander mit verschiedenen Kontaktstellen (81) der elektrischen Schaltung (61) verbunden sind, und Ausführen von Messungen durch die Messvorrichtung (15) bei jeweils verschiedenen Ansteuerungen der Schaltmatrix (27),
wobei das Kontaktieren der mehreren Kontaktstellen (81) umfasst: Auswählen eines der mehreren Prüfkontakte (9), Berühren einer an das Prüfsystem (1) angeschlossenen Kontaktidentifikationsfläche (95) mit dem ausgewählten Prüfkontakt (9), Ausführen einer Messung durch die Messvorrichtung (15) bei jeweils verschiedenen Ansteuerungen der Schaltmatrix (27), und
Identifizieren des ausgewählten Prüfkontakts (9) basierend auf einem Ergebnis der Messung.

6. Verfahren nach Anspruch 5, ferner umfassend:
Anzeigen einer Darstellung der Kontaktstellen (81) auf einem Monitor und Anzeigen einer zweiten Markierung (93), welche anzeigt, welche der Kontaktstellen (81) in einem nächsten Verfahrensschritt mit einem Prüfkontakt (9) kontaktiert werden soll.

7. Verfahren nach Anspruch 5 oder 6, wobei die Prüfkontakte (9) jeweils einen Magneten umfassen, und wobei das Kontaktieren der Kontaktstellen (81) ein Befestigen der Prüfkontakte (9) an den Kontaktstellen mittels Magnetkraft umfasst.

8. Verfahren nach einem der Ansprüche 1 bis 7, ferner umfassend Auswerten der durch die Messvorrichtung (15) durchgeführten Messungen und Ermitteln eines Fehlers in der elektrischen Schaltung (61).

9. Verfahren nach Anspruch 8, ferner umfassend Beheben des ermittelten Fehlers in der elektrischen Schaltung (61).
